# EUROPEAN PATENT APPLICATION

(11) **EP 2 091 151 A1**
(43) Date of publication of application: **19.08.2009**
(21) Application number: 09001634.6
(22) Date of filing: 05.02.2009
(51) Int. Cl.: H03J 5/24

(54) **Television tuner**

(30) Priority: 13.02.2008 JP 2008031669
(71) Applicant: Alps Electric Co., Ltd., Tokyo 145-8501 (JP)
(72) Inventor: Yamamoto, Masaki, Tokyo, 145-8501 (JP)
(74) Representative: Klunker . Schmitt-Nilson . Hirsch

(57) **Abstract**

In the television tuner, between an input part of a VHF tuning circuit (2) and the ground, inductor grounded circuits (11, 12) that ground via inductors are formed. Further, to the inductor grounded circuits (11, 12), a switch diode (D2) that operates in synchronization with a VHF high band reception operation and a switch diode (D1) that turns on/off at a reception of a certain channel are disposed in parallel. By the on/off operation of the switch diodes (D1, D2), at a reception of UHF/VHF high band, a HPF for suppressing a signal in a low band side to a reception frequency is formed, and at a reception of VHF low band, a LPF that suppresses a signal in a high band side to a reception frequency is formed.

## Description

### BACKGROUND OF THE INVENTION

### 1. Field of the Invention

The present invention relates to a television tuner for selectively receives first and second bands.

### 2. Description of the Related Art

Conventionally, a television tuner that uses an attenuation characteristic in a low band side by a high-pass filter (HPF) to attenuate signals in VHF band at a reception of UHF band in order to obtain a suppression effect in VHF band has been proposed (for example, see Japanese Unexamined Patent Application Publication No. 10-322169). Meanwhile, a television tuner in which a serial resonance circuit formed by capacitors and inductors is connected to a prestage of a VHF band input tuning circuit to attenuate a signal in VHF low band when VHF high band is received in order to obtain a suppression effect in VHF low band has been proposed (for example, see Japanese Unexamined Patent Application Publication No. 2003-309455). Fig. 7 is a view illustrating a circuit configuration of the television tuner described in Japanese Unexamined Patent Application Publication No. 10-322169. A VHF tuner unit 101 that receives a television signal in VHF band and a UHF tuner unit 102 that receives a television signal in UHF band are connected to an input terminal 103. The VHF tuner unit 101 includes an intermediate frequency trap circuit 104, a VHF input tuning circuit 105, and a VHF high-frequency amplifier 106. The UHF tuner unit 102 includes a direct current blocking capacitor 107, a varactor diode 108 that functions as a coupling capacitor, a UHF input tuning circuit 109, and a UHF high-frequency amplifier 110. The UHF input tuning circuit 109 further includes an impedance conversion circuit 111 and a main tuning circuit 112 that is connected in parallel with the impedance conversion circuit 111. The impedance conversion circuit 111 includes an inductor 113 and an inductor 114 that are interconnected in series. One end of the inductor 113 is grounded. The main tuning circuit 112 includes a main inductor 115 and a varactor diode 116 that is connected in parallel with the main inductor 115 and functions as a tuning capacitor. One end of the inductor 114 that forms the impedance conversion circuit 111 is connected to one end of the main inductor 115 and one end (anode) of the varactor diode 116 that form the main tuning circuit 112. By the configuration, the impedance conversion circuit 111 and the main tuning circuit 112 are connected in parallel, and the UHF input tuning circuit 109 is formed. A capacitor 117 that is connected in series to the other end of the main inductor 115 and a capacitor 118 that is connected between the other end (cathode) of the varactor diode 116 and the ground are used to block a direct current.

In the television tuner configured as described above, the varactor diode 108 operates as a HPF, and the varactor diode 108 and the inductor 113 form a trap circuit. Accordingly, if a serial resonance frequency of the varactor diode 108 and the inductor 113 is set to a frequency in VHF band, a television signal in VHF band can be greatly attenuated.

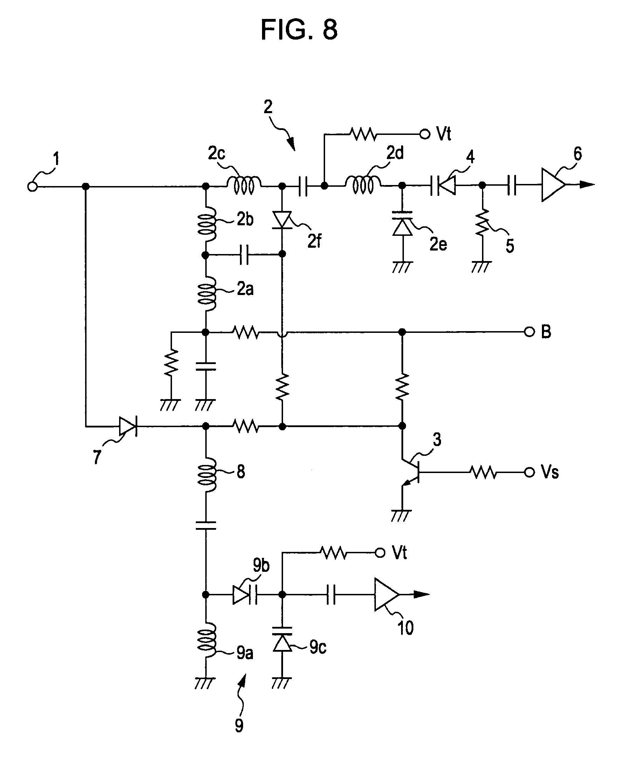

Fig. 8 is a view illustrating a circuit configuration of the television tuner described in Japanese Unexamined Patent Application Publication No. 2003-309455. To an input terminal 1, a VHF tuning circuit 2 is coupled. The VHF tuning circuit 2 includes four inductance elements 2a to 2d that are connected in series, a tuning varactor diode 2e that is connected in parallel with the entire of the four inductance elements, and a switch diode 2f that is connected in parallel with the entire of the two intermediate inductance elements 2b and 2c in the inductance elements 2a to 2d. A connection point of the two intermediate inductance elements 2b and 2c in the four inductance elements 2a to 2d is connected to the input terminal 1. To an anode of the switch diode 2f, a voltage B is applied via the inductance elements 2a to 2c, and a cathode is connected to a collector of a switch transistor 3. An emitter is earthed. To a base of the switch transistor 3, a high level or low level switch voltage Vs is applied. An anode of the tuning varactor diode 2e is grounded, and to a cathode, a tuning voltage Vt is applied. To the cathode of the tuning varactor diode 2e, a cathode of the coupling varactor diode 4 is connected. The anode is grounded by a bias resistance 5, and coupled to a VHF high-frequency amplifier 6. Further, to the input terminal 1, an UHF tuning circuit 9 is coupled via a switch diode 7 and a coupling inductance element 8 in series. To an anode of the switch diode 7, the voltage B is applied, and a cathode is connected to the collector of the switch transistor 3. The UHF tuning circuit 9 tunes to a channel in UHF band. The UHF tuning circuit 9 includes an inductance element 9a and two tuning varactor diodes 9b and 9c whose cathodes are interconnected with each other and the diodes are connected in parallel with the inductance element 9a. To the cathodes, a tuning voltage Vt is applied. The cathodes are coupled to a UHF high-frequency amplifier 10.

In the television tuner configured as described above, when a television signal in VHF low band is received, the switch diode 2f and the switch diode 7 are turned off, and by the inductance elements 2a to 2d and the tuning varactor diode 2e in the VHF tuning circuit 2, a tuning frequency is set. Accordingly, the VHF tuning circuit 2 is separated from the UHF tuning circuit 9, and the VHF tuning circuit 2 can perform an original function without being affected by the UHF tuning circuit 9.

Further, when a television signal in VHF high band is received, the switch diode 2f and the switch diode 7 are turned on, the inductance elements 2b and 2c are connected in parallel, and the inductance elements 2a and 2d are connected in series. Then, by the inductance elements 2a and 2d and the tuning varactor diode 2e, a tuning frequency is set. In such a case, the entire of the coupling inductance element 8 and the inductance element 9a in the UHF tuning circuit 9 that are connected in series, and the inductance elements 2b and 2c that are connected in series in the VHF tuning circuit 2 step up the signal source impedance at the input terminal 1 side, and a connection is established with the VHF tuning circuit 2 (in this case, configured by the inductance elements 2a and 2d and the tuning varactor diode 2e). Accordingly, tuning selectivity is increased.

In the television tuner described in Japanese Unexamined Patent Application Publication No. 10-322169, it is possible to obtain the suppression effect in VHF band. However, the serial resonance frequency of the capacitors and inductors that form the HPF is within UHF band. Accordingly, the suppression effect in VHF low band at the reception of VHF high band is insufficient.

Further, in the television tuner described in Japanese Unexamined Patent Application Publication No. 2003-309455, it is possible to obtain the suppression effect in VHF low band. However, at the reception of UHF band, any attenuation means for the low band side is not provided. Accordingly, the suppression effect in VHF band is insufficient. Further, the inductors form the UHF antenna tuning circuit and it is prioritized to ensure an ANT selection characteristic. Accordingly, it is difficult to configure an optimal setting to VHF band, and the improvement of the selection characteristic in VHF band has been desired.

### SUMMARY OF THE INVENTION

The present invention has been made to solve the above problems. The present invention provides a television tuner that can sufficiently attenuate a 1/n (especially, 1/2) frequency in a low band side to a reception frequency when a plurality of bands such as UHF, VHF high band, and VHF low band are selectively received, can attenuate an image frequency in a high band side reception channel to the reception frequency, and a frequency selection characteristic to the plurality of bands is improved.

The television tuner includes an input terminal (1) in which television signals including a first and second bands are inputted, a first input tuning circuit (2) connected to the input terminal (1), the first input tuning circuit (2) selects the television signals of the first and second bands, a first amplifier circuit (6) connected to the first input tuning circuit (2), a first inductor (11) connected to the input terminal (1) at one end, a second inductor (12) connected to the other end of the first inductor (11) at one end and grounded in a high frequency manner at the other end, a first switching element (D2) connected between the other end of the first inductor (11) and one end of the second inductor (12), and a capacitor (15) connected between both ends of the first switching element (D2). In the television tuner, by tuning the first switching element (D2) off, a resonance frequency of a serial resonance circuit (11, 12, 15) formed by the first and second inductors (11, 12) and the capacitor (15) is set to a frequency higher than a maximum frequency of the first band that is to be a low band side in the first and second bands, when a television signal in the first band is received, the first switching element (D2) is turned off, and when a television signal in the second band is received, the first switching element (D2) is turned on.

By the configuration, at the reception of the television signal in the first band, by turning the first switching element off, by the combined inductor of the first and second inductors and the capacity of the capacitor, a trap for attenuating an image band can be formed in the high band side of the first band. Further, at the reception of the television signal in the second band, by turning the first switching element on, the input end of the first input tuning circuit can be grounded by the combined inductor of the first and second inductors, and the frequency characteristic in the low band side can be improved.

In the present invention, the television tuner may further include a second switching element (D1) connected between a connection point of the first inductor (11) and the first switching element (D2) and the ground. When a television signal in the first band is received, the first and second switching elements (D2, D1) are turned off, when a television signal in the low band side in the second band is received, the first switching element (D2) is turned on, and the second switching element (D1) is turned off, and when a television signal in the high band side in the second band is received, both of the first and second switching elements (D2, D1) are turned on.

By the configuration, when the television signal in the low band side in the second band is received, the first switching element is turned on, and the second switching element is turned off. Thus, the input end of the first input tuning circuit can be grounded by the combined inductor of the first and/or second inductors, and the frequency selection characteristic in the low band side can be improved. Further, when the television signal in the high band side in the second band is received, by turning both of the first and second switching elements on, the second inductor is shorted via the first switching element. Then, the inductor that grounds the input end of the first input tuning circuit is only the first inductor, and the frequency selection characteristic can be further improved.

In the present invention, the television tuner may further include a second input tuning circuit (9) connected to the input terminal (1), the second input tuning circuit (9) selects a television signal in a third band including higher frequencies than the second band, a second amplifier circuit (10) connected to the second input tuning circuit (9), and a tuning high-pass filter (11, 21, 22, 24) connected between the input terminal (1) and the second input tuning circuit (9), the tuning high-pass filter (11, 21, 22, 24) performs a tuning in synchronization with the second input tuning circuit (9). When a television signal in the third band is received, the first switching element (D2) is turned off, and the second switching element (D1) is turned on.

By the configuration, the tuning high-pass filter can be provided in the input stage of the second tuning circuit. when the television signal in the third band is received, by turning the first switching element off and turning the second switching element on, the signals in the first and second bands contained in the television signals to be inputted to the second input tuning circuit can be attenuated by the tuning high-pass filter.

In the present invention, in the television tuner, by turning the first switching element (D2) off, the resonance frequency of the serial resonance circuit (11, 12, 15) formed by the first and second inductors (11, 12) and the capacitor (15) is set to an image frequency at the time of receiving the television signal in the first band.

In the television tuner, the first band may be VHF low band, the second band may be VHF high band, and the third band may be UHF band.

According to the present invention, at a reception of VHF high band, a frequency selection characteristic in a low band side to a reception frequency can be improved. At a reception of VHF low band, an image trap can be formed in a high band side of a reception frequency.

### BRIEF DESCRIPTION OF THE DRAWINGS

Fig. 1 is a view illustrating a circuit configuration of a television tuner according to an embodiment of the present invention.
Fig. 2 is a view illustrating a relationship between reception bands and on and off states of switch diodes according to the embodiment of the present invention.
Fig. 3 is a view illustrating a relationship between switch signals BS1 and BS2 and switch frequencies according to the embodiment of the present invention.
Fig. 4A is a view illustrating a result of a simulation of an attenuation quantity in an image trap when 129 MHz is received according to the embodiment of the present invention. Fig. 4B is a view illustrating a result of a simulation of an attenuation quantity in an image trap when 129 MHz is received in a known circuit.
Fig. 5A is a view illustrating a result of a simulation of an attenuation quantity in a low frequency side when 134.7 MHz is received according to the embodiment of the present invention. Fig. 5B is a view illustrating a result of a simulation of an attenuation quantity in a low frequency side when 134.7 MHz is received in a known circuit.
Fig. 6A is a view illustrating a result of a simulation of an attenuation quantity in a low frequency side when 207 MHz is received according to the embodiment of the present invention. Fig. 6B is a view illustrating a result of a simulation of an attenuation quantity in a low frequency side when 207 MHz is received in a known circuit.

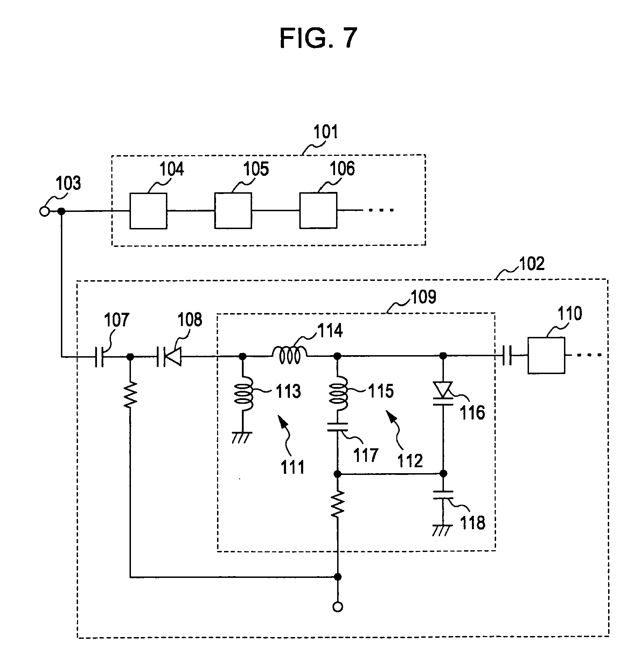

Fig. 7 is a view illustrating a circuit configuration of the television tuner described in Japanese Unexamined Patent Application Publication No. 10-322169.
Fig. 8 is a view illustrating a circuit configuration of the television tuner described in Japanese Unexamined Patent Application Publication No. 2003-309455.

### DESCRIPTION OF THE PREFERRED EMBODIMENTS

Hereinafter, an embodiment of the present invention is described in detail with reference to the attached drawings.

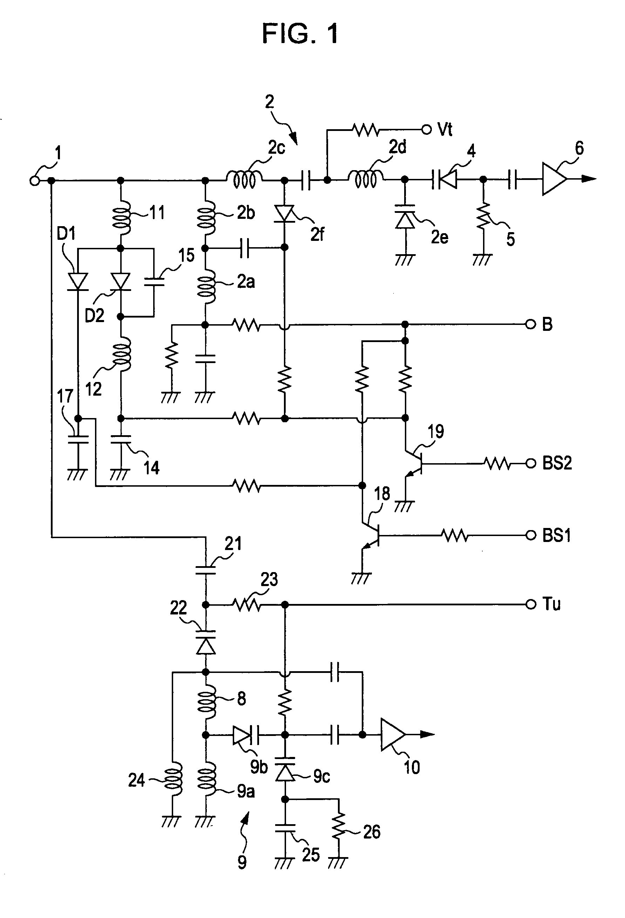

Fig. 1 illustrates a circuit configuration of a television tuner according to the embodiment of the present invention. To the same parts as elements in the television tuner illustrated in Fig. 8, the same reference numerals are applied and overlapped descriptions are omitted. The television tuner according to the embodiment has a grounded circuits (11, 12) that are grounded via inductors between an input part of the VHF tuning circuit 2 and the ground and switch circuits (D1, D2) that are connected to the rounded circuits (11, 12) to switch inductor values of the grounded circuits (11, 12). The switch circuits (D1, D2) provides a function of a HPF that suppresses a signal in a low band side to a reception frequency when UHF/VHF high band are received. Capacitors (14, 15) are disposed such that the capacitors has a function of a LPF that suppresses a signal in a high band side to a reception frequency when VHF low band is received. Capacitance values of the capacitors (14, 15) are set such that a trap for attenuating an image band (a high band side to a reception frequency) at the time of VHF low band reception is formed. Hereinafter, a specific circuit configuration is described. An input end (connection point of the inductance elements 2b and 2c), which is connected to the input terminal 1, in the VHF tuning circuit 2 that functions as a first tuning circuit is grounded in a high frequency manner via first and second inductance elements 11 and 12 and a capacitor 14 in series. Between the first inductance element 11 and the second inductance element 12, the switch diode D2 is connected. The switch diode D2 has a cathode that faces the second inductance element 12 side and the switch diode D2 is to function as a first switching element. Between both ends of the switch diode D2, a capacitor 15 is connected. A connection point of the first inductance element 11 and an anode of the switch diode D2 is grounded via the switch diode D1 that is to be a second switching element in a forward direction. A cathode of the switch diode D1 is grounded at a capacitor 17 in a high frequency manner. A first switch transistor 18 for turning on or off the switch diode D1 and a second switch transistor 19 for turning on or off the switch diodes 2f and D2 are provided. The switch diode D1 is set so as to be in a conductive state when a certain channel is received. In the embodiment, the switch diode D1 is set so as to be in the conductive state at a high frequency or more in a case where VHF high band is divided into a low band range and a high band range.

In the first switch transistor 18, to a base, a switch signal BS1 is applied, to a collector, the voltage B is always applied, and an emitter is grounded. The collector in the first switch transistor 18 is connected to the cathode of the switch diode D1.

In the second switch transistor 19, to a base, a switch signal BS2 is applied, to a collector, the voltage B is always applied, and an emitter is grounded. The collector in the second switch transistor 19 is connected to the cathodes of the switch diodes D2 and 2f in a direct current manner. The other configurations of the VHF tuning circuit 2 are similar to those of the circuit configuration illustrated in Fig. 8.

Further, in the television tuner according to the embodiment, a frequency-variable type HPF is formed on a signal path between the input terminal 1 and an input part of the UHF tuning circuit 9 that functions as a second tuning circuit. That is, to an end of the coupling inductance element 8 that is to be an input part of the light receiver 9, a fixed-capacity capacitor 21 and a variable-capacity varactor diode 22 are connected. To a connection point of the capacitor 21 and the varactor diode 22, a tuning voltage Tu can be applied via a bias resistance 23. The tuning voltage Tu is simultaneously applied to cathodes of the tuning varactor diodes 9b and 9c. An anode of the varactor diode 22 is grounded in a direct current manner via a third inductance element 24. An anode of the tuning varactor diode 9c is grounded in a high frequency manner via a capacitor 25 and also grounded in a direct current manner via a resistance 26. The other configurations of the UHF tuning circuit 9 are similar to those of the circuit configuration illustrated in Fig. 8.

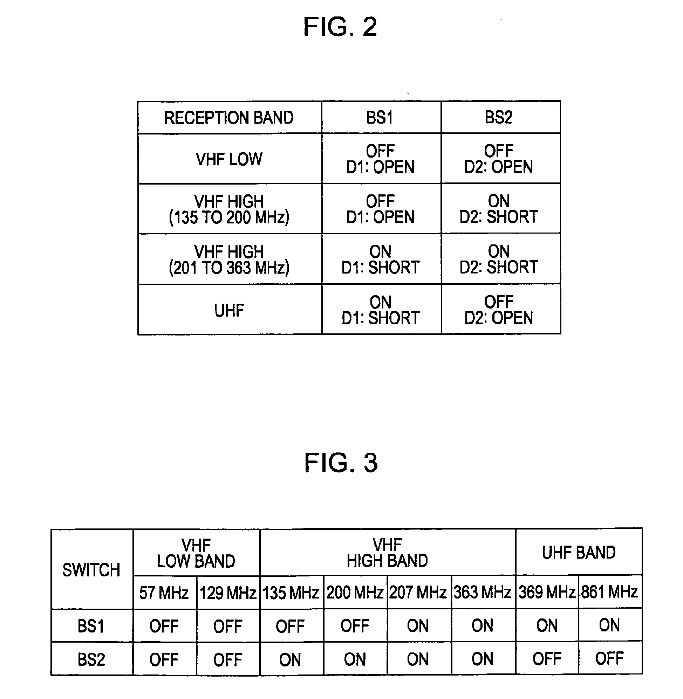

Now, operation of the television tuner configured as described above is described. Fig. 2 is a view illustrating a relationship between reception bands (VHF low band, VHF high band (high band range/low band range), and UHF) and on and off states of the switch diodes D1 and D2 in the VHF tuning circuit 2 according to the embodiment of the present invention. Fig. 3 is a view illustrating a relationship between the switch signals BS1 and BS2 and switch frequencies.

As illustrated in Figs. 2 and 3, when VHF low band is received, the switch signals BS1 and BS2 are controlled to be at low levels respectively. When the switch signal BS1 applied to the base of the first switch transistor 18 is at the low level, the first switch transistor 18 is in a nonconductive state. Then, the voltage B being applied to the collector terminal is applied to the cathode of the switch diode D1. As a result, to the switch diode D1, a reverse bias that makes the switch diode D1 to have a high potential at the cathode side is applied, and the switch diode D1 is in an off state. When the switch signal BS2 applied to the base of the second switch transistor 19 is at the low level, the second switch transistor 19 is in the nonconductive state. Then, the voltage B being applied to the collector terminal is applied to the cathode of the switch diode D2. As a result, to the switch diode D2, a reverse bias that makes the switch diode D2 to have a high potential at the cathode side is applied, and the switch diode D2 is in the off state. When the switch diodes D1 and D2 are turned off and in open states, a serial resonance circuit is formed by a combined inductor of the first and second inductance elements 11 and 12 and a combined capacity of the capacitors 14 and 15. Such a serial resonance circuit forms a trap for attenuating an image band at the time of the VHF low band reception (image trap at the reception of 129 MHz).

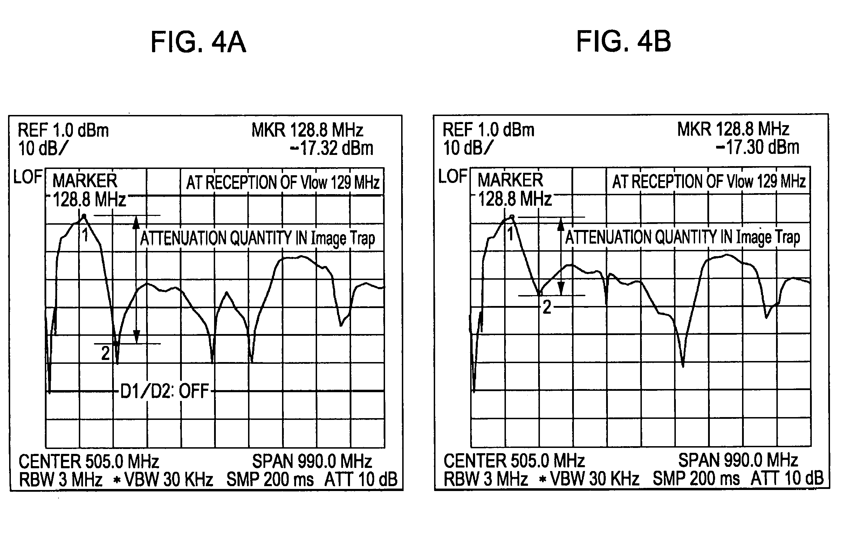

Fig. 4A is a view illustrating a result of a simulation of an attenuation quantity in an image trap when 128.8 MHz is received according to the embodiment of the present invention. Fig. 4B is a view illustrating a result of a simulation of an attenuation quantity in an image trap when 128.8 MHz is received in the known circuit illustrated in Fig. 8. As illustrated in the drawings, it is understood that in the embodiment, a greater attenuation quantity can be ensured as the image trap at the reception of 129 MHz as compared to the known circuit.

Now, operation at a VHF high band reception is described. In the VHF high band reception, inductor values of the inductor grounded circuits are switched in a low band side (135 MHz to 200 MHz) and in a high band side (201 MHz to 363 MHz) of VHF high band to switch a frequency of the HPF formed in the input part of the VHF tuning circuit 2. In the embodiment, the boundary between the low band side and the high band side of VHF high band is set to 200 MHz. However, the boundary can be appropriately changed depending on designs.

At a reception of the low band side (135 MHz to 200 MHz) in VHF high band, as illustrated in Figs. 2 and 3, it is controlled such that the switch signal BS1 is to be at a low level and the switch signal BS2 is to be at a high level. Since the switch signal BS1 is at the low level, the switch diode D1 remains in the open state. Meanwhile, in response to the switching of the switch signal BS2 to the high level, the second switch transistor 19 is in the conductive state and the cathode voltage of the switch diode D2 is reduced. Then, between the both ends of the switch diode D2, a bias is applied in a forward direction, and the switch diode D2 is in the conductive state. As a result, the input end of the VHF tuning circuit 2 is grounded via a combined inductor of the first and second inductance elements 11 and 12. As described above, by grounding the input end of the VHF tuning circuit 2, the frequency selection characteristic in the low band side in VHF high band can be improved, and signal loss can be minimized.

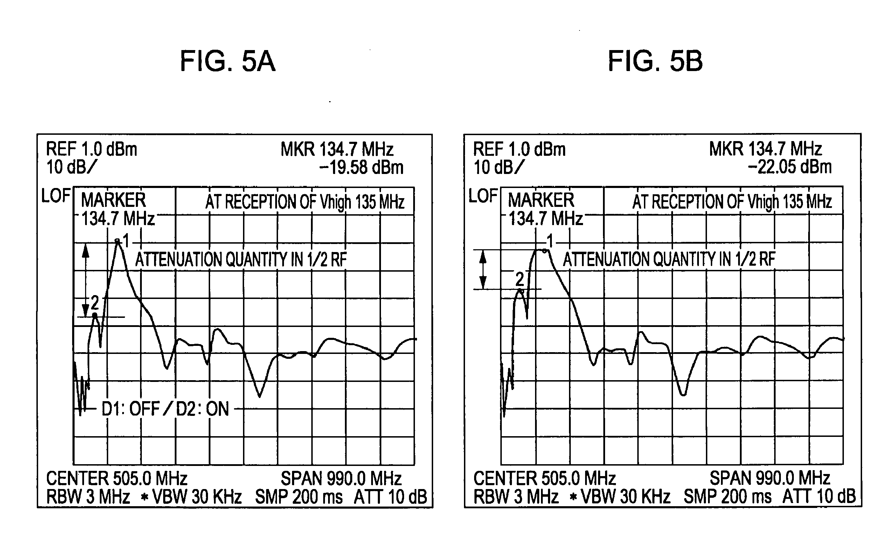

Fig. 5A is a view illustrating a result of a simulation of an attenuation quantity in a 1/2 frequency in the low band side when 134.7 MHz is received according to the embodiment of the present invention. Fig. 5B is a view illustrating a result of a simulation of an attenuation quantity in a 1/2 frequency in the low band side when 134.7 MHz is received in the known circuit illustrated in Fig. 8. As illustrated in the drawings, in the embodiment, the input end of the VHF tuning circuit 2 is grounded by the combined inductor of the first and second inductance elements 11 and 12. Accordingly, as compared to the known circuit, the attenuation quantity in the 1/2 frequency in the low band side can be greatly increased.

At a reception of the high band side (201 MHz to 363 MHz)in VHF high band, as illustrated in Figs. 2 and 3, it is controlled such that the switch signals BS1 and BS2 are to be at the high level. Meanwhile, in response to the switching of the switch signal BS1 to the high level, the first switch transistor 18 is in the conductive state and the cathode voltage of the switch diode D1 is reduced. Then, between the both ends of the switch diode D1, a bias is applied in a forward direction, and the switch diode D1 is in the conductive state. Further, since the switch signal BS2 is at the high level, the second switch transistor 19 is in the conductive state and the cathode voltage of the switch diode D2 is reduced. Then, between the both ends of the switch diode D2, a bias is applied in the forward direction, and the switch diode D2 is in the conductive state. As a result, the second inductance element 12 is shorted at the switch diode D1, and only the first inductance element 11 grounds the input end of the VHF tuning circuit 2. Accordingly, the frequency selection characteristic at a 1/n frequency in the low band side to the reception frequency (the high band side in VHF high band) can be further improved.

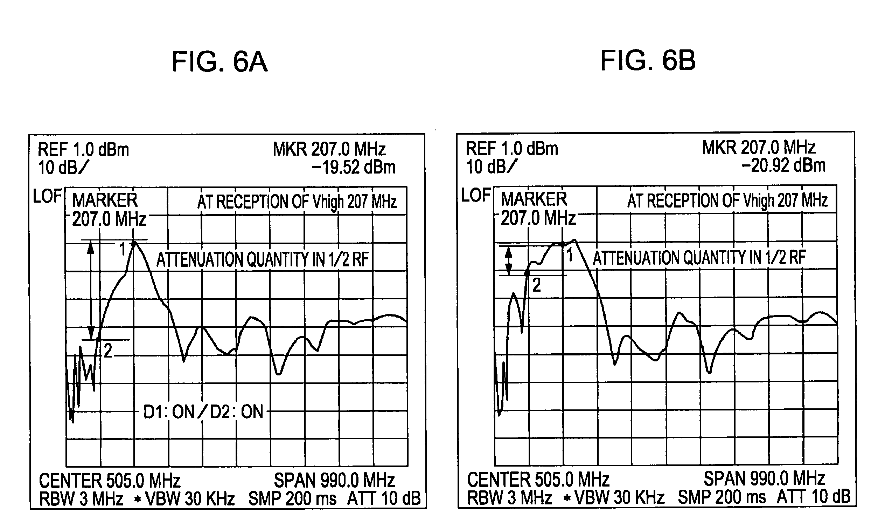

Fig. 6A is a view illustrating a result of a simulation of an attenuation quantity in a 1/2 frequency in the low band side when 207 MHz is received according to the embodiment of the present invention. Fig. 6B is a view illustrating a result of a simulation of an attenuation quantity in a 1/2 frequency in the low band side when 207 MHz is received in the known circuit illustrated in Fig. 8. As illustrated in the drawings, in the embodiment, it is understood that by grounding the input end of the VHF tuning circuit 2 using only the first inductance element 11, the attenuation quantity at the 1/2 low band side can be further increased, and the selection characteristic is improved. As described above, by switching the switch signals B1 and B2, switching inductor values depending on a reception in the low band side or a reception in the high band side within the same band (VHF high band), and switching a frequency of the HPF, the frequency selection characteristic in the low band side can be improved.

Now, operation at a UHF band reception is described. In the UHF band reception, it is controlled such that the switch signal BS1 is at a high level, and the switch signal BS2 is at a low level. Since the switch signal BS1 is at the high level, the switch diode D1 is in a conductive state, the switch diode D2 is in a nonconductive state, and becomes an open state. As a result, a frequency-variable type HPF is formed by the third inductance element 24, a combined capacity (variable) of the varactor diode 22 and the capacitor 21, and the first inductance element 11. The HPF has a high signal attenuation capability in VHF band as compared to the known HPF of the half band. Accordingly, the reception sensitivity in UHF band can be improved.

In the above description, as an example, it is defined that the first band is VHF low level, the second band is VHF high level, and the third band is UHF band. However, the present invention is not limited to the above band definition. The present invention can be similarly applied to any television tuner that can receive television signals of a plurality of bands and select a television signal of a desired band via an input tuning circuit. Further, it is not always necessary that the low band of the television signals includes as many as bands to the third band.

The present invention can be applied to a television tuner that switches VHF high band and VHF low band to receive a signal.

## Claims

1. A television tuner comprising:
an input terminal (1) in which television signals including a first and second bands are inputted;
a first input tuning circuit (2) connected to the input terminal (1), the first input tuning circuit (2) selects the television signals of the first and second bands;
a first amplifier circuit (6) connected to the first input tuning circuit (2);
a first inductor (11) connected to the input terminal (1) at one end;
a second inductor (12) connected to the other end of the first inductor (11) at one end and grounded in a high frequency manner at the other end;
a first switching element (D2) connected between the other end of the first inductor (11) and one end of the second inductor (12); and
a capacitor (15) connected between both ends of the first switching element (D2),
wherein by tuning the first switching element (D2) off, a resonance frequency of a serial resonance circuit (11, 12, 15) formed by the first and second inductors (11, 12) and the capacitor (15) is set to a frequency higher than a maximum frequency of the first band that is to be a low band side in the first and second bands,
when a television signal in the first band is received, the first switching element (D2) is turned off, and
when a television signal in the second band is received, the first switching element (D2) is turned on.

2. The television tuner according to Claim 1, further comprises a second switching element (D1) connected between a connection point of the first inductor (11) and the first switching element (D2) and the ground,
wherein when a television signal in the first band is received, the first and second switching elements (D2, D1) are turned off,
when a television signal in the low band side in the second band is received, the first switching element (D2) is turned on, and the second switching element (D1) is turned off, and
when a television signal in the high band side in the second band is received, both of the first and second switching elements (D2, D1) are turned on.

3. The television tuner according to Claim 2, further comprising:
a second input tuning circuit (9) connected to the input terminal (1), the second input tuning circuit (9) selects a television signal in a third band including higher frequencies than the second band;
a second amplifier circuit (10) connected to the second input tuning circuit (9); and
a tuning high-pass filter (11, 21, 22, 24) connected between the input terminal (1) and the second input tuning circuit (9), the tuning high-pass filter (11, 21, 22, 24) performs a tuning in synchronization with the second input tuning circuit (9),
wherein when a television signal in the third band is received, the first switching element (D2) is turned off, and the second switching element (D1) is turned on.

4. The television tuner according to any one of Claim 1 to Claim 3, wherein by turning the first switching element (D2) off, the resonance frequency of the serial resonance circuit (11, 12, 15) formed by the first and second inductors (11, 12) and the capacitor (15) is set to an image frequency at the time of receiving the television signal in the first band.

5. The television tuner according to Claim 3 or Claim 4, wherein the first band is VHF low band, the second band is VHF high band, and the third band is UHF band.
